(19) Europäisches Patentamt
European Patent Office
Office européen des brevets

(11) **EP 2 678 873 B1**

(12) **EUROPÄISCHE PATENTSCHRIFT**

(45) Veröffentlichungstag und Bekanntmachung des Hinweises auf die Patenterteilung:
**17.02.2016  Patentblatt 2016/07**

(21) Anmeldenummer: **12705669.5**

(22) Anmeldetag: **23.02.2012**

(51) Int Cl.:
*H01F 27/28* (2006.01)     *H01F 27/32* (2006.01)
*H01B 7/30* (2006.01)     *H02K 3/14* (2006.01)

(86) Internationale Anmeldenummer:
**PCT/EP2012/053048**

(87) Internationale Veröffentlichungsnummer:
**WO 2012/113851 (30.08.2012 Gazette 2012/35)**

(54) **KONTINUIERLICHER DRILLLEITER**

CONTINUOUSLY TRANSPOSED CONDUCTOR

CONDUCTEUR TORSADÉ CONTINU

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.02.2011  AT 2522011**

(43) Veröffentlichungstag der Anmeldung:
**01.01.2014  Patentblatt 2014/01**

(73) Patentinhaber: **Asta Elektrodraht GmbH
2755 Oed/Wiener Neustadt (AT)**

(72) Erfinder:
• **TRIMMEL, Thomas
2824 Seebenstein (AT)**

• **TRIMMEL, Martin
2824 Seebenstein (AT)**

(74) Vertreter: **Patentanwälte Pinter & Weiss OG
Prinz-Eugen-Straße 70
1040 Wien (AT)**

(56) Entgegenhaltungen:
EP-A1- 0 981 139     EP-A1- 2 325 849
EP-A2- 0 133 220     WO-A1-98/14964
WO-A2-2011/009729     CN-A- 101 673 588
CN-U- 201 508 700     CN-U- 201 549 337
CN-Y- 201 435 232     US-A- 4 276 102

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die gegenständliche Erfindung betrifft ein Verfahren zum Herstellen eines kontinuierlichen Drillleiters, bestehend aus einer Mehrzahl einzelner, elektrisch isolierter Einzelleiter mit einer den jeweiligen Einzelleiter umgebenden Isolationsschicht, wobei jeweils zwei oder mehrere Einzelleiter zur Ausbildung von Einzelleitergruppen jeweils übereinander an einer Berührfläche aneinander liegend angeordnet werden.

Unter einem kontinuierlichen Drillleiter wird ein Drillleiter verstanden, der in großen Längen gefertigt wird, z.B. sind Längen von einigen tausend Metern keine Seltenheit, und die in weiterer Folge zu einer Wicklung einer elektrischen Maschine, z.B. eine Transformatorwicklung, verarbeitet werden. Durch den Wickelvorgang erfahren die Drillleiter eine starke Krümmung. Im Gegensatz werden Wicklungsstäbe bzw. Roebelstäbe mit geringer Länge manuell gefertigt und zu einer Wicklung einer elektrischen Maschine (z.B. ein Elektromotor oder Generator) zusammengebaut, indem die geraden Stäbe in Nuten am Rotor eingelegt werden und die axialen Enden der Stäbe anschließend auf bestimmte Weise miteinander verbunden werden, um die Wicklung zu bilden. Ein solcher Wicklungsstab wird dabei ebenfalls aus einer Reihe mit einander verdrillten Einzelleitern hergestellt, wobei ein fertiger Wicklungsstab in Zuge seiner Weiterverarbeitung aber niemals gekrümmt oder irgendwie sonst verbogen wird, sodass dessen verdrillten Teilleiter bzw. Teilleitergruppen dabei immer in Position bleiben. Es treten somit bei kontinuierlichen Drillleitern und bei Wicklungsstäben bei deren Weiterverarbeitung prinzipiell andere Problem auf, weshalb diese nicht direkt miteinander vergleichbar sind.

Bekannterweise treten bei Transformatoren vor allem im Hauptteil (Mittelteil) der Wicklung elektromagnetische Axialfelder (Längsfelder) auf, welche in den Wicklungsleitern Wirbelströme induzieren, die zu Wirbelstromverlusten führen. Wirbelstromverluste reduzieren den Wirkungsgrad des Transformators, führen aber auch zu lokal unerwünscht hohen Temperaturen, die wiederum zu einer Beschädigung der Wicklungsisolation führen kann. Durch die Verwendung von bekannten kontinuierlichen Drillleitern können solche Wirbelstromverluste reduziert werden. Drillleiter bestehen dabei aus einem Bündel von einzelnen, isolierten Teilleitern, die einzeln gegeneinander verdrillt werden, z.B. nach dem Roebelprinzip, wie z.B. in Fig. 1 dargestellt. Solche kontinuierliche Drillleiter sind z.B. aus der EP 746 861 B1 bekannt und werden dabei maschinell und automatisiert mit Längen von einigen tausend Metern hergestellt und zur Verschiffung auf Trommeln aufgewickelt. Drillleiter zeichnen sich insbesondere auch dadurch aus, dass diese ausreichend biegeweich sind, um zur Herstellung von Wicklungen gewickelt werden zu können.

Für Wicklungsstäbe bzw. Roebelstäbe ist es aus der AT 309 590 B auch bereits bekannt, die Verdrillung so vorzusehen, dass immer zwei benachbarte Teilleiter gemeinsam verdrillt werden. Damit soll neben dem Ausgleich des Längsfeldes durch die Verdrillung auch das sich bereits schädlich machende Radialfeld innerhalb einer Nut kompensiert werden. Roebelstäbe, die nach wie vor hauptsächlich manuell hergestellt werden, indem Teilleiter geringer Länge auf speziellen Werkbänken durch einen Arbeiter manuell verdrillt werden, können auf diese Weise einfach hergestellt werden, auch wenn zwei benachbarte Teilleiter gemeinsam verdrillt werden. Roebelstäbe werden jedoch nicht gewickelt, sondern es wird aus mehreren Roebelstäben eine Wicklung "gebaut", indem die Enden der Roebelstäbe entsprechend verbunden werden.

Die Anforderungen an heutige Transformatoren steigen jedoch immer mehr, zum Einen hinsichtlich Größe und Leistung und zum Anderen hinsichtlich Wirkungsgrad und Reduktion von Verlusten hervorgerufen z.B. durch Wirbelstromverluste. Speziell bei sehr großen leistungsstarken Transformatoren treten unerwünschte signifikante Wirbelstromverluste auf Grund der magnetischen Felder auf. Weiters ist die Reduktion der Hotspot Temperatur, das Spannungsverhalten und der Füllfaktor von großer Bedeutung in der Auslegung der Transformatorenwicklungen.

Bei derzeit bekannten Drillleitern ist durch deren Geometrie und Fertigungsmöglichkeit die Verbesserung der oben genannten Eigenschaften durch physikalische Grenzen im Drillleiter-Fertigungsprozess nicht möglich. Die Anzahl der möglichen Drillleiter-Einzelleiter, die zu einem Drillleiter verdrillt werden können, ist durch den sogenannten Verdrillfaktor limitiert. Der Verdrillfaktor $f_D$ wird durch folgende bekannte Berechnungsformel abhängig vom inneren Transformator-Wicklungsdurchmesser, der Anzahl der Einzelleiter des Drillleiters und der Breite des Einzelleiters beschrieben:

$$f_D = \frac{WD \cdot \pi}{n \cdot b_1}$$

Dabei bedeutet

WD     kleinster Wickeldurchmesser
n        Anzahl der Einzelleiter
$b_1$       Einzelleiterbreite

Durch die derzeitige Fertigungstechnologie ist es möglich Drillleiter bis zu einem minimalen Verdrillfaktor $f_D$=5 zu fertigen, wobei die Anzahl der Einzelleiter bzw. die Drahtbreite und Wicklungsdurchmesser in Abhängigkeit stehen. Diese fertigungstechnische Limitierung des Verdrillfaktors beschränkt die Herstellbarkeit der Drillleiter mit steigender Einzelleiteranzahl.

In einer Transformatorenwicklung mit herkömmlichen Drillleitern ist weiters die Spannungsverteilung problematisch, da durch Spannungsdifferenzen zwischen den parallel geführten Drillleitern unerwünschte Kapazitäten entstehen. Außerdem entstehen signifikante Wirbelstromverluste und dadurch auch hohe Temperaturen im Drillleiter bzw. in der Wicklung.

Bei der Verwendung von einer Mehrzahl von Einzelleitern, die gemeinsam als Einzelleiterbündel zu einem Drillleiter verdrillt werden, können die entstehenden Wirbelstromverluste und damit die Hotspot Temperaturen reduziert werden. Ein solcher Drillleiter ist z.B. aus der EP 133 220 A2 bekannt, bei dem Seile aus einer Gruppe von runden Einzelleitern zu einem elektrischen Leiter verdrillt werden. Ähnliches zeigt die US 4 431 860 A, wobei die Einzelleiter der einzelnen Seile in sich wieder verdrillt sind. Damit kann die Einzelleiteranzahl erhöht werden und trotzdem die physikalische Limitierung des Drillfaktors mit fünf eingehalten werden. Bei der Verwendung von runden Einzelleitern, wie in der EP 133 220 A2 ergibt sich allerdings ein schlechter Füllfaktor, wodurch der Querschnitt des Drillleiters bei vorgegebenem Kupferquerschnitt unerwünscht groß wird. In einer Ausgestaltung der Seile können die runden Einzelleiter im Paket rechteckig verformt werden, was zwar den Füllfaktor etwas verbessert, allerdings einen zusätzlichen Arbeitsschritt benötigt und dadurch die Herstellung aufwendiger wird.

Die Drillleiter der EP 133 220 A2 und der US 4 431 860 A haben aber den entscheidenden Nachteil der aufwendigen Fertigung, da zuerst ein Teilleiter aus einer Anzahl von Einzeldrähten durch Verdrillen der Einzeldrähte gefertigt werden muss und erst dann dieser kompakte Teilleiter zum Drillleiter verdrillt wird. Damit ergibt sich zumindest ein zusätzlicher aufwendiger Arbeitsschritt mit allen damit verbundenen Nachteilen, wie Lagerung und Handhabung der Einzeldrähte und der Teilleiter, verschiedene Verdrillanlagen, längere Produktionszeiten, etc. Deshalb hat man bisher eher davon abgesehen, in der Praxis solche Drillleiter nach dem Stand der Technik zu verwenden. Durch die Verdrillung der Einzeldrähte erreichte man allerdings einen kompakten, in sich stabilen Teilleiter, in dem sich die Einzelleiter relativ zueinander nicht verschieben können und der so für die nachfolgende Verdrillung zu einem Drillleiter geeignet ist. Nur so konnten bisher Drillleiter mit Teilleitern aus mehreren Einzelleitern gefertigt werden.

Die WO 2011/009729 A2 beschreibt einen Drillleiter mit Einzelleitergruppen bestehend aus mehreren Einzelleitern, wobei die Einzelleitergruppen zum Drillleiter verdrillt werden. Bei diesem Drillleiter werden die Einzelleiter aber lose aneinander liegend angeordnet.

Bei der gemeinsamen Verdrillung von lose übereinander liegenden Teilleitern kann es passieren, dass sich die einzelnen Teilleiter relativ zueinander verschieben, was den fertigen Drillleiter aber unbrauchbar machen würde. Es konnten bisher in einem kontinuierlichen Herstellprozess zur Herstellung eines kontinuierlichen Drillleiters nicht zwei oder mehrere übereinander liegende Einzelleiter in einem Arbeitsschritt gemeinsam verdrillt werden. Eine solche Herstellung eines Drillleiters war daher bisher aus produktionstechnischen Gründen nicht beherrschbar. Außerdem kann ein Drillleiter mit Teilleitern mit lose übereinander liegenden Einzelleitern nicht zu einer Wicklung verarbeitet werden, da sich die Einzelleiter aufgrund derer sich in der Wicklung ergebenden unterschiedlichen radialen Lagen relativ zueinander verschieben oder sich der radial innere Einzelleiter aufwölben könnte. Ein solcher

Drillleiter kann daher auch nicht zu einer Wicklung weiterverarbeitet werden.

WO 98/14964 A1, US 4 276 102 A, CN 201 435 232 Y, CN 201 549 337 U, CN 101 673 588 A, CN 201 508 700 U offenbaren einen aus mehreren Einzelleitern bestehen kontinuierlichen Drillleiter. Jeder Einzelleiter ist - ganz oder teilweise - mit einer adhesiven Schicht (z.B. Epoxidharz) versehen um den Zusammenhalt des Gesamtleiters zu verbessern. Diese Schicht wird nach dem Verdrillen zum Gesamtleiter ausgehärtet.

Es ist daher eine Aufgabe der gegenständlichen Erfindung, ein Herstellverfahren für einen Drillleiter mit gemeinsam verdrillten, übereinander liegenden Einzelleitern anzugeben, das eine einfachere Herstellung des Drillleiters ermöglicht.

Diese Aufgabe wird erfindungsgemäß durch ein Verfahren nach Anspruch 1 gelöst. Hierbei werden zwei benachbarte, übereinander angeordnete Einzelleiter einer Einzelleitergruppe an ihrer Berührfläche durch Verkleben kraftschlüssig miteinander verbunden werden und danach die Einzelleitergruppen zum kontinuierlichen Drillleiter verdrillt werden. Das kraftschlüssige Verbinden von zwei Einzelleitern an deren Berührfläche vor dem Verdrillen zu einem Drillleiter ist produktionstechnisch wesentlich einfacher, als das Verdrillen solcher Einzelleiter zu einem Teilleiter. Gleichzeitig wird durch die kraftschlüssige Verbindung sichergestellt, dass der Drillleiter, wie üblich, hochkant zu einer Wicklung gewickelt werden kann, da damit verhindert wird, dass sich die auf unterschiedlichen Radien befindlichen Einzelleiter gegeneinander verschieben, oder sich der radial innere Einzelleiter beim Wickeln aufwölbt.

Es ist produktionstechnisch vorteilhaft, wenn die übereinander angeordneten Einzelleiter einer Einzelleitergruppe mit rechteckförmigen Einzelleiterquerschnitt ausgeführt werden und die Einzelleiter der Einzelleitergruppe an ihrer Längsseite an einer Berührfläche aneinander liegend angeordnet werden.

Besonders vorteilhaft werden alle benachbarten, übereinander angeordneten Einzelleiter jeweils an ihrer Berührfläche durch Verkleben kraftschlüssig miteinander verbunden.

Falls die Einzelleiter in der Einzelleitergruppe in einer n x n- oder n x m-Anordnung angeordnet sind ist es vorteilhaft, auch zwei benachbarte, nebeneinander angeordnete Einzelleiter an ihrer Berührfläche kraftschlüssig miteinander zu verbinden, bevorzugt miteinander zu verkleben, da damit ein besonders stabiler Teilleiter erzielt werden, der sicher zu einem Drillleiter verarbeitbar ist und dieser Drillleiter auch sicher gewickelt werden kann. Das wird noch weiter verbessert, wenn alle benachbarten, nebeneinander angeordneten Einzelleiter jeweils an ihrer Berührfläche durch Verkleben kraftschlüssig kraftschlüssig miteinander verbunden.

Das kraftschlüssige Verbinden der Einzelleiter kann vereinfacht werden, wenn die Kanten der Einzelleiter abgerundet ausgeführt sind und die Abrundungen der Kanten eines Einzelleiters einer Einzelleitergruppe, die eine Berührfläche zwischen zwei nebeneinander und/oder übereinander liegenden Einzelleitern begrenzen, mit einem kleineren Radius ausgeführt sind, als die Radien der Abrundungen der äußeren Kanten der Einzelleitergruppe. Damit erreicht man eine größere verfügbare Fläche zum Verbinden der Einzelleiter. Das bewirkt auch eine sicherere Verbindung der Einzelleiter.

Wenn in einem erfindungsgemäßen Drillleiter die Dicke der Isolationsschicht eines Einzelleiters zwischen 0,03 und 0,08mm, vorzugsweise 0,06mm, ausgeführt ist, kann der Füllfaktor eines solchen Drillleiters verbessert werden, da damit dem durch die größere Anzahl von Einzelleiter im Drillleiter bedingten erhöhten Lackanteil im Drillleiter wirkungsvoll durch eine Reduktion der Lackschicht entgegengewirkt werden kann.

Die Spannungsverteilung in einer bekannten Transformatorenwicklung mit herkömmlichen parallel gewickelten Drilleitern ist wesentlich schlechter als bei Verwendung von erfindungsgemäßen Drillleitern mit geteilten Einzelleitern. In herkömmlichen Transformatorwicklungen entstehen durch Spannungsdifferenzen der parallel geführten Drilleiter Kapazitäten, die bei der Verwendung eines erfindungsgemäßen Drilleiters mit geteilten Einzelleitern nicht auftreten, da die Einzelleiter im Gesamtbündel miteinander verdrillt werden. Weiters ergibt sich durch die Vereinigung der parallelen Drilleiter zu einem Drillleiter mit geteilten Einzelleitern in Summe eine Verbesserung des Füllfaktors und der Transformator wird kompakter in den Außenabmessungen. Somit ist die Verwendung eines erfindungsgemäßen Drilleiters in einer Transformatorwicklung besonders vorteilhaft.

Die gegenständliche Erfindung wird nachfolgend anhand der beispielhaften und nicht einschränkenden, vorteilhafte Ausgestaltungen zeigenden Figuren 1 bis 4 beschrieben. Dabei zeigt

Fig. 1 einen herkömmlichen Drillleiter nach dem Stand der Technik
Fig. 2 einen erfindungsgemäßen Drillleiter mit einer Einzelleitergruppe mit übereinander angeordneten Einzelleitern,
Fig. 3 einen Querschnitt durch einen erfindungsgemäßen Drillleiter und
Fig. 4 einen Querschnitt eines erfindungsgemäßen Drillleiter mit einer Einzelleitergruppe mit einer n x n-Anordnung von Einzelleitern.

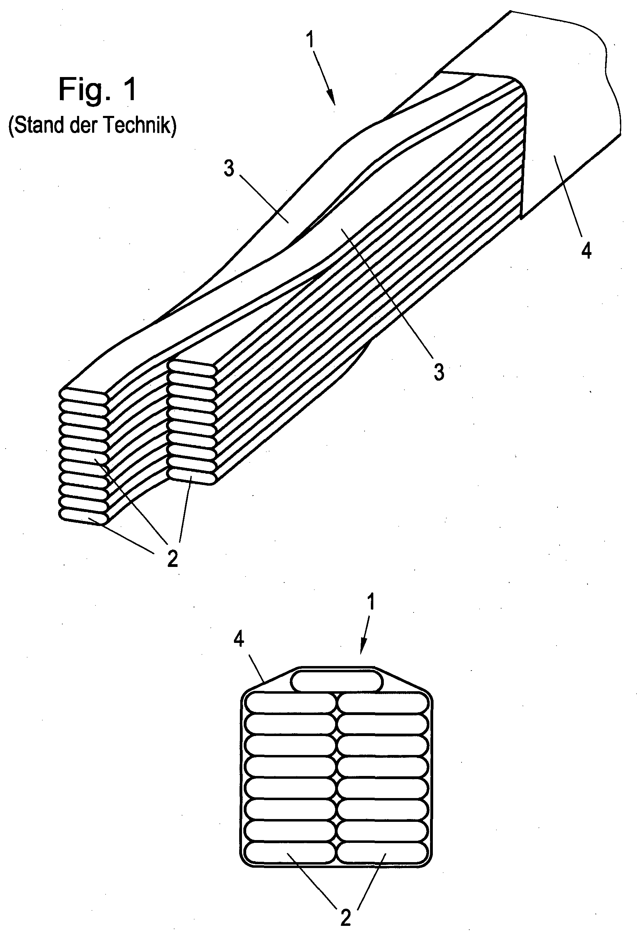

Fig. 1 zeigt einen hinlänglich bekannten Drillleiter 1 bestehend aus einer Anzahl von elektrisch isolierten Einzelleitern 2, die in zwei Einzelleiterstapeln 3 angeordnet sind. Die Einzelleiter 2 werden dabei bekanntermaßen so verdrillt, dass diese von der obersten in die unterste Lage wechseln. Ein Einzelleiter 2 hat dabei einen rechteckigen Querschnitt und abgerundete Kanten. Um das Zusammenhalten des Einzelleiterbündels zu einem Drillleiter 1 zu gewährleisten oder um den Drillleiter zu schützen, kann auch eine Umwicklung 4 durch ein Webband, einen Papierstreifen oder ähnlichem vorgesehen sein.

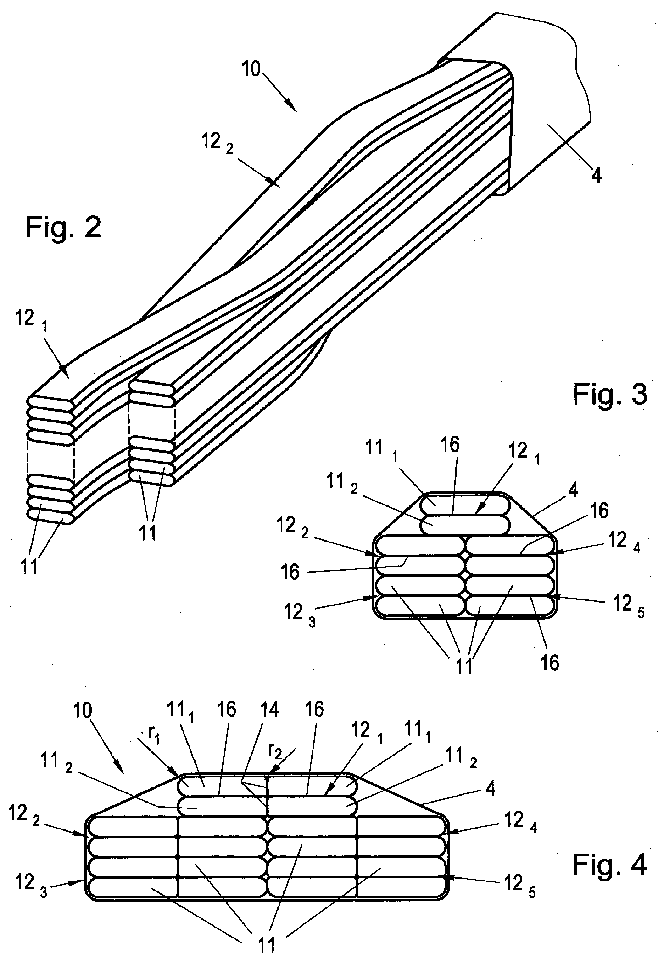

Ein erfindungsgemäßer Drillleiter 10 ist in den Figuren 2 und 3 dargestellt, der aus einer Vielzahl von einzelnen elektrisch isolierten Einzelleitern 11 besteht. Bei diesem Drillleiter 10 werden jeweils zwei übereinander liegende Einzelleiter 11 zu einer Einzelleitergruppe 12 zusammengefasst und gemeinsam verdrillt. "Übereinander" bedeutet hierbei bei einem rechteckigen Einzelleiterquerschnitt, dass die Einzelleiter 11 an ihrer Längsseite an einer Berührfläche 16 aneinander liegend angeordnet sind. Eine Einzelleitergruppe 12 könnte aber auch mehr als zwei übereinander angeordnete Einzelleiter 11 und damit mehrere Berührflächen 16 zwischen jeweils zwei der Einzelleiter 11 umfassen.

Der Drillleiter 10 kann dabei wieder mit einer Umwicklung 4, z.B. zum Schutz der Einzelleiter 11 beim Transport oder zur Stabilisierung des Drillleiters 10, umgeben sein.

In einer Transformatorwicklung wird der Drillleiter 10 hochkant gewickelt, demzufolge liegt ein Einzelleiter $11_1$ der Einzelleitergruppe $12_1$ auf einem größeren Wicklungsradius als der Einzelleiter $11_2$ derselben Gruppe. Dasselbe gilt für die anderen Einzelleitergruppen $12_2$ bis $12_5$. Um zu verhindern, dass sich die Einzelleiter $11_1$, $11_2$ der Einzelleitergruppen 12 beim Verdrillen oder Wickeln relativ zueinander verschieben oder sich die radial inneren Einzelleiter $11_2$ beim Wickeln aufwölben, sind die Einzelleiter $11_1$, $11_2$ der Einzelleitergruppen 12 an ihren Berührflächen 16 (bezogen auf die Wicklung in radialer Richtung) durch Verklebung Kraftschlüssig mitelnander verbunden.

In einer anderen möglichen Ausgestaltung des erfindungsgemäßen Drillleiters 10 umfasst eine Einzelleitergruppe 12 mehrere neben- und übereinander angeordnete Einzelleiter 11, wie z.B. eine n x n-Anordnung von Einzelleitern 11, wie in Fig. 4 dargestellt, oder n x m-Anordnung von Einzelleitern 11. Die nebeneinander liegenden Einzelleiter 11 liegen dabei an einer zweiten Berührfläche 14 aneinander und die übereinander liegenden Einzelleiter 11 liegen an einer ersten Berührfläche 16 aneinander. Die nebeneinander liegenden Einzelleiter 11 der Einzelleitergruppe 12 können ebenfalls an ihrer Berührfläche 14 (bezogen auf die Wicklung in axialer Richtung) durch Verkleben Kraftschlüssig miteinander verbunden. Damit wird auch sichergestellt, dass sich die nebeneinander liegenden Einzelleiter 11 beim seitlichen Verschieben im Verdrillprozess nicht gegeneinander verschieben und die Einzelleiter 11 damit innerhalb der Einzelleitergruppe 12 in der vorgesehenen Position bleiben.

Alternativ oder zusätlich zur kraftschlüssigen Verbindung an den Schmalseiten der Einzelleiter (den Berührflächen 14) kann auch vorgesehen sein, dass die

Radien $r_2$ der Abrundungen der Kanten, die die Berührfläche 14 der benachbarten Einzelleiter 11 der Einzelleitergruppe 12 begrenzen, kleiner sind, als die Abrundungen der äußeren Kanten der Einzelleitergruppe, wie in Fig. 4 dargestellt. Die "äußeren" Kanten sind dabei die Kanten des sich ergebenden rechteckigen (oder quadratischen) Querschnitts der Einzelleitergruppe 12. Grundsätzlich kann es auch schon ausreichend sein, überhaupt nur eine oder an jedem Einzelleiter 11 jeweils nur eine dieser Kanten mit einem kleineren Radius $r_2$ abzurunden. Aus Sicht des Füllfaktors ist es aber besser, alle diese Kanten der Einzelleiter 11 mit einem kleineren Radius $r_2$ abzurunden. Damit ergibt sich durch die kleinen Radien $r_2$ eine ausreichend große Berührfläche 14, die ein Übereinander- oder Untereinanderschieben der Einzelleiter 11 beim Verdrillvorgang, bei dem die Einzelleitergruppe 12 ja seitlich verschoben werden muss, verhindert. Hingegen könnte bei den außen notwendigen großen Radien $r_1$ die Einzelleiter sehr einfach an den Radien aneinander abgleiten und ein solches Übereinander- oder Untereinanderschieben der Einzelleiter 11 sehr einfach passieren, was den Verdrillvorgang praktisch unmöglich machen würde.

Zusätzlich könnten auch eine oder alle Kanten, die die Berührflächen 16 zwischen zwei benachbarten übereinander liegenden Einzelleiter 11 begrenzen mit einem kleineren Radius $r_2$ ausgeführt, wie in Fig. 4 an der Einzelleitergruppe $12_5$ dargestellt.

Das Vorsehen von kleineren Radien $r_1$ an den die Berührflächen 14, 16 begrenzenden Kanten hat auch den Vorteil, dass dadurch eine größere effektive Fläche für die kraftschlüssige Verbindung, z.B. eine größere Klebefläche, verfügbar ist.

Ein erfindungsgemäßer Drillleiter 10 kann nun auch besonders vorteilhaft in einer Transformatorwicklung eingesetzt werden, wobei ein erfindungsgemäß ausgeführter Drillleiter 10 zwei herkömmliche, parallel gewickelte Drillleiter (z.B. nach Fig. 1) ersetzen kann, da im erfindungsgemäßen Drillleiter 10 ja deutlich mehr, z.B. doppelt so viele, Einzelleiter 11 vorhanden sind.

Ein erfindungsgemäßer Drillleiter 10 hat bei gleichem Querschnitt einen geringeren Füllfaktor als ein herkömmlicher Drillleiter, da jeder Einzelleiter 11 isoliert sein muss und durch die größere Anzahl von Einzelleitern 11 natürlich auch mehr Isolation im Querschnitt vorhanden ist. Die Isolationsschicht eines Einzelleiters 11 ist laut anzuwendender Norm bei Grad 1 0,1mm und bei Grad 2 0,15mm. In heutigen Drillleitern kommt praktisch nur mehr die Güteklasse Grad 1 zur Anwendung. Um den Füllfaktor in einem erfindungsgemäßen Drillleiter 10 bei gleichem Querschnitt zu verbessern, kann vorgesehen sein, die Dicke der Isolationsschicht zu verringern, bevorzugt auf einen Bereich von 0,03 bis 0,08mm, vorzugsweise auch 0,06mm.

**Patentansprüche**

1. Verfahren zum Herstellen eines kontinuierlichen Drillleiters, bestehend aus einer Mehrzahl einzelner, elektrisch isolierter Einzelleiter (11) mit einer den jeweiligen Einzelleiter (11) umgebenden Isolationsschich mit einer Dicke von 0,15 mm, 0,1 mm oder zwischen 0,03 mm und 0,08 mm, vorzugsweise 0,06 mm, wobei

   - jeweils zwei oder mehrere Einzelleiter (11) zur Ausbildung von Einzelleitergruppen (12) jeweils übereinander an einer Berührfläche (16) aneinander liegend angeordnet werden,
   - zwei benachbarte, übereinander angeordnete Einzelleiter (11) einer Einzelleitergruppe (12) an ihrer Berührfläche (16) durch Verkleben kraftschlüssig miteinander verbunden werden und danach
   - die Einzelleitergruppen (12) zum kontinuierlichen Drillleiter (10) verdrillt werden.

2. Verfahren nach Anspruch 1, **dadurch gekennzeichnet, dass** die übereinander angeordneten Einzelleiter (11) einer Einzelleitergruppe (2) mit rechteckförmigen Einzelleiterquerschnitt ausgeführt werden und die Einzelleiter (11) der Einzelleitergruppe (2) an ihrer Längsseite an einer Berührfläche (16) aneinander liegend angeordnet werden.

3. Verfahren nach Anspruch 1 oder 2, **dadurch gekennzeichnet, dass** alle benachbarten, übereinander angeordneten Einzelleiter (11) einer Einzelleitergruppe (12) jeweils an ihrer Berührfläche (16) durch Verkleben kraftschlüssig miteinander verbunden werden.

4. Verfahren nach einem der Ansprüche 1 bis 3, **dadurch gekennzeichnet, dass** die Einzelleiter (11) in der Einzelleitergruppe (16) in einer n x n- oder n x m-Anordnung angeordnet werden und zwei benachbarte, nebeneinander angeordnete Einzelleiter (11) der Einzelleitergruppe (2) an ihrer Berührfläche (14) durch Verkleben kraftschlüssig miteinander verbunden werden.

5. Verfahren nach Anspruch 4, **dadurch gekennzeichnet, dass** alle benachbarten, nebeneinander angeordneten Einzelleiter (11) der Einzelleitergruppe (12) jeweils an ihrer Berührfläche (14) durch Verkleben kraftschlüssig miteinander verbunden werden.

**Claims**

1. A method for producing a continuously transposed conductor, consisting of a plurality of individual, electrically isolated single conductors (11) with an insulation layer, having a thickness of 0.15 mm, 0.1 mm or between 0.03 mm and 0.08 mm, preferably 0.06 mm, surrounding each single conductor (11), whereby

- in each case two or more single conductors (11) are arranged above each other and are contacting each other on a contact surface (16) to form a single conductor group (12),
- two adjacent conductors (11) of a single conductor group (12) that are arranged above each other are joined non-positively to each other by adhesive bonding at their contact surface (16), and thereafter
- the single conductor group (12) is transposed to form the continuously transposed conductor (10).

2. A method according to claim 1, **characterized in that** the single conductors (11) of a single conductor group (12) that are arranged above each other are implemented with rectangular single conductor cross-section and the single conductors (11) of the single conductor group (12) are contacting each other on a contact surface (16) arranged on the longitudinal side thereof.

3. A method according to claim 1 or 2, **characterized in that** all adjacent single conductors (11) of a single conductor group (12) that are arranged above each other are non-positively joined to each other in each case at the contact surface (16) thereof by adhesive bonding.

4. A method according to any one of claims 1 to 3, **characterized in that** the single conductors (11) in the single conductor group (12) are arranged in a nxn or nxm arrangement and two adjacent single conductors (11) of a single conductor group (12) that are arranged alongside each other are non-positively joined to each other at the contact surface (16) thereof by adhesive bonding.

5. A method according to claim 4, **characterized in that** all adjacent single conductors (11) of a single conductor group (12) that are arranged alongside each other are non-positively joined to each other in each case at the contact surface (16) thereof by adhesive bonding.

**Revendications**

1. Procédé de fabrication d'un conducteur torsadé continu constitué d'une pluralité de conducteurs individuels (11) isolés électriquement et comportant une couche isolante entourant les conducteurs individuels (11) respectifs, la couche isolante ayant une épaisseur de 0,15 mm, de 0,1 mm, ou comprise entre 0,03 mm et 0,08 mm, de préférence de 0,06 mm,

- deux conducteurs individuels (11) ou plus étant disposés de façon adjacente et superposée pour former des groupes de conducteurs individuels (12) au niveau d'une surface de contact (16),
- deux conducteurs individuels (11) adjacents et superposés d'un même groupe de conducteurs individuels (12) étant reliés entre eux de manière adhésive par collage au niveau de leur surface de contact (16) puis
- les groupes de conducteurs individuels (12) étant tordus pour former les conducteurs torsadés continus (10).

2. Procédé selon la revendication 1, **caractérisé en ce que** les conducteurs individuels (11) superposés d'un même groupe de conducteurs individuels (2) sont réalisés avec une section transversale rectangulaire et les conducteurs individuels (11) du groupe de conducteurs individuels (2) sont disposés de façon adjacente sur leur côté longitudinal au niveau d'une surface de contact (16).

3. Procédé selon la revendication 1 ou 2, **caractérisé en ce que** tous les conducteurs individuels (11) adjacents et superposés d'un même groupe de conducteurs individuels (12) sont reliés entre eux de manière adhésive par collage au niveau de leur surface de contact (16).

4. Procédé selon l'une des revendications 1 à 3, **caractérisé en ce que** les conducteurs individuels (11) du groupe de conducteurs individuels (16) sont disposés selon une matrice n x n ou n x m et deux conducteurs individuels (11) adjacents, placés l'un à côté de l'autre, du groupe de conducteurs individuels (2) sont reliés entre eux de manière adhésive par collage au niveau de leur surface de contact (16).

5. Procédé selon la revendication 4, **caractérisé en ce que** les conducteurs individuels (11) adjacents, disposés les uns à côté des autres, du groupe de conducteurs individuels (12) sont reliés entre eux de manière adhésive par collage au niveau de leur surface de contact (14).

# Fig. 1

(Stand der Technik)

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 746861 B1
- AT 309590 B
- EP 133220 A2
- US 4431860 A
- WO 2011009729 A2
- WO 9814964 A1
- US 4276102 A
- CN 201435232 Y
- CN 201549337 U
- CN 101673588 A
- CN 201508700 U